## Europäisches Patentamt

## European Patent Office

## Office européen des brevets

(11) Veröffentlichungsnummer: **0 074 133**
**B1**

(12) **EUROPÄISCHE PATENTSCHRIFT**

(45) Veröffentlichungstag der Patentschrift:
**28.01.87**

(21) Anmeldenummer: **82201010.4**

(22) Anmeldetag: **12.08.82**

(51) Int. Cl.⁴: **H 01 L 29/10, H 01 L 29/743**

(54) **Thyristor.**

(30) Priorität: **25.08.81 CH 5465/81**

(43) Veröffentlichungstag der Anmeldung:
**16.03.83 Patentblatt 83/11**

(45) Bekanntmachung des Hinweises auf die Patenterteilung:
**28.01.87 Patentblatt 87/5**

(84) Benannte Vertragsstaaten:
**CH DE FR GB LI SE**

(56) Entgegenhaltungen:
**EP - A - 0 030 370**
**DE - A - 2 456 743**
**US - A - 3 855 611**

(73) Patentinhaber: **BBC Aktiengesellschaft Brown, Boveri & Cie., Haselstrasse, CH-5401 Baden (CH)**

(72) Erfinder: **Sittig, Roland, Dr., Rinikerstrasse 102, CH-5222 Umiken (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft ein Halbleiterbauelement gemäss dem Oberbegriff des Anspruchs 1. Ein solches Halbleiterbauelement ist z.B. aus der US-PS 3 855 611 bekannt.

Bei diesem bekannten Halbleiterbauelement mit seiner Folge von vier abwechselnd dotierten Schichten ist in der inneren N-dotierten Zone, der N-Basiszone, eine Zwischenschicht mit erhöhter Dotierungskonzentration von beispielsweise $5{,}2 \cdot 10^{15} \, \mathrm{cm}^{-3}$ vorgesehen.

Weiterhin ist aus den IEEE Transactions on Electron Devices, Vol. ED-23, No. 8 (1976), S. 823 ein Halbleiterbauelement bekannt, welches in seiner einfachsten Ausführung einen asymmetrischen Thyristor darstellt, der eine höhere Sperrfähigkeit in Vorwärtsrichtung als in Rückwärtsrichtung besitzt.

Bei Vorwärtspolung liegt an der die äussere P-Zone kontaktierenden Hauptelektrode (Anode) eine positive Spannung gegenüber der die äussere N-Zone kontaktierenden Hauptelektrode (Kathode) an. In der Praxis wird der asymmetrische Thyristor oft durch Integration einer antiparallelen Diode als rückwärtsleitender Thyristor ausgeführt. Die hohe Sperrfähigkeit in Vorwärtsrichtung verdankt das bekannte Halbleiterbauelement vor allem einer Dotierungsüberhöhung in dem an die äussere P-Zone angrenzenden Teilbereich der inneren N-Zone. Bei anliegender Vorwärtssperrspannung bildet sich am PN-Übergang zwischen der inneren N- und P-Zone eine Sperrschicht aus, die sich mit wachsender Sperrspannung in diesen Zonen ausdehnt. Die Dotierungsüberhöhung in dem Teilbereich der inneren N-Zone hat vor allem die Aufgabe, diese Ausdehnung der Sperrschicht aufzuhalten, und damit den sogenannten «punch through» des Thyristors zu verhindern, der auftritt wenn der Rand der Sperrschicht einen der benachbarten äusseren und vorwärtsgepolten PN-Übergänge, vorwiegend den anodenseitigen, erreicht und diesen zur Ladungsträgeremission stimuliert. Der Durchbruch des Thyristors erfolgt dann erst bei höherer Spannung durch den sogenannten Lawineneffekt, wenn die elektrische Feldstärke in der Sperrschicht einen kritischen Wert überschreitet. Entsprechend seiner Stoppfunktion für die Ausdehnung der Sperrschicht wird der überhöht dotierte Teilbereich der inneren N-Zone auch als Stoppschicht bezeichnet.

Zur Optimierung der Sperreigenschaften des Bauelements werden an die Stoppschicht die folgenden Forderungen gestellt:

– Ihre Dotierung sollte möglichst hoch sein, um die Ausdehnung der Sperrschicht wirksam zu stoppen,

– Sie sollte ausreichend dick sein, damit der Transportfaktor für die von der anodenseitigen P-Zone injizierten Minoritätsladungsträger stark genug reduziert wird und dadurch kein unzulässig hoher Anteil am Sperrstrom verursacht wird.

Zur Optimierung der Durchlasseigenschaften und des Durchschaltens nach dem Zünden über die Steuerelektrode wird dagegen gefordert:

– eine möglichst niedrige Dotierung der Stoppschicht, sowie

– eine geringe Dicke der Stoppschicht, um die Durchlassspannung zu reduzieren.

Diesen konträren Forderungen wurde bisher durch einen wenig befriedigenden Kompromiss Rechnung getragen. Zum einen durch einen mittleren konstanten Dotierungsgrad in der Stoppschicht zwischen $2 \cdot 10^{16} \, \mathrm{cm}^{-3}$ und $1 \cdot 10^{17} \, \mathrm{cm}^{-3}$. Zum anderen durch eine Dicke der Stoppschicht von etwa der eineinhalbfachen bis doppelten Diffussionslänge der Minoritätsladungsträger.

Daneben ist in der DE-OS 2 941 021 zur Verbesserung des Emitterwirkungsgrades die Einführung einer weiteren schwach dotierten Zone zwischen die Stoppschicht und die äussere P-Zone erwähnt, doch sind die zur Dimensionierung dieser Zone angegebenen Daten in keinem realen Bauelement definiert.

Der Erfindung liegt daher die Aufgabe zugrunde, die Eigenschaften des Halbleiterbauelements bezüglich aller an die Stoppschicht gestellten Forderungen mit technisch einfachen Mitteln zu verbessern.

Diese Aufgabe wird erfindungsgemäss gelöst durch die Merkmale des Anspruchs 1.

Die besonderen Vorteile der Erfindung ergeben sich vor allem durch die Absenkung der Dotierungskonzentration der Stoppschicht vor der angrenzenden äusseren P-Zone. Dadurch wird das Einschaltverhalten des Thyristors verbessert und der Transportfaktor für die von der anodenseitigen P-Zone injizierten Löcher zwischen den Betriebszuständen Sperren und Durchlass im gewünschten Sinn verändert:

Sperren – kleiner Transportfaktor auf Grund des sich entlang des Konzentrationsgradienten in der Stoppschicht aufbauenden elektrischen Feldes.

Durchlass – grosser Transportfaktor, da die gesamte Stoppschicht von freien Ladungsträgern überschwemmt ist, und das elektrische Feld nicht mehr auftritt.

Dadurch wird es sogar möglich, die Dicke der Stoppschicht zu reduzieren, wodurch die Durchlassspannung in vorteilhafter Weise kleiner wird.

Weitere Merkmale und Vorteile der Erfindung ergeben sich aus dem nachstehend anhand von Zeichnungen erläuterten Ausführungsbeispiel.

Dabei zeigt:

Fig. 1 einen Querschnitt durch das Halbleiterbauelement,

Fig. 2 in einem Diagramm das Dotierungsprofil des Halbleiterbauelements senkrecht zur Schichtung der Zonen und

Fig. 3 in einem Diagramm die Abhängigkeit des Transportfaktors β von der Stromdichte.

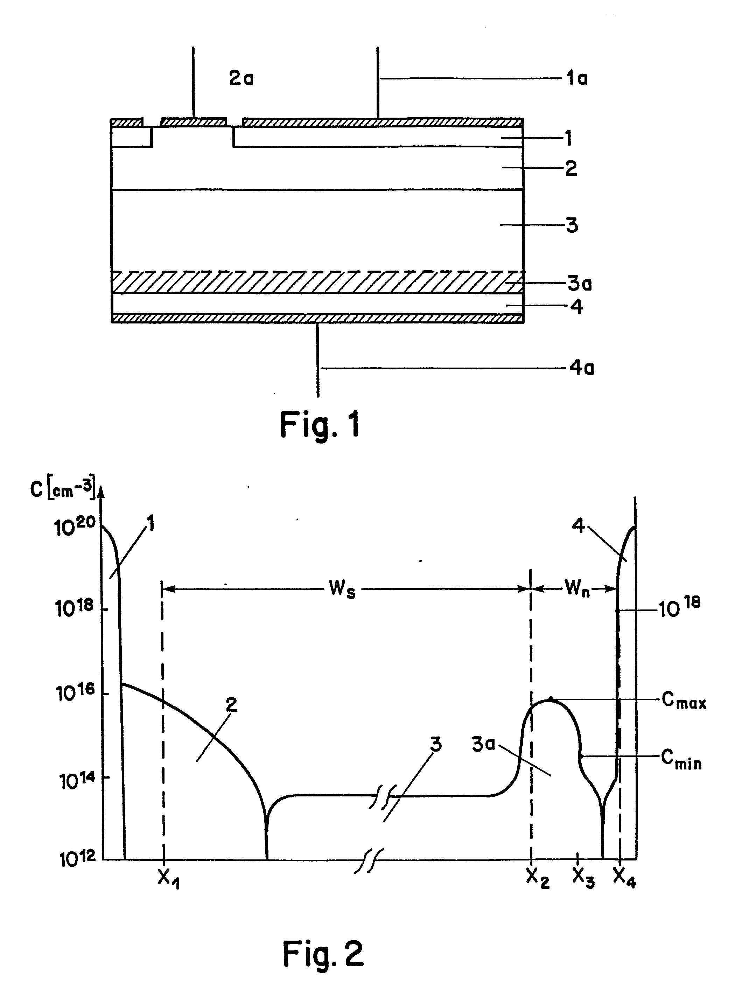

Gemäss Fig. 1 besteht das Halbleiterbauelement in seiner einfachsten Ausführung als asymmetrischer Thyristor aus vier Zonen abwechselnd entgegengesetzten Leitungstyps, einer kathodenseitigen N-Zone 1 (N-Emitter), einer inneren P-Zone 2 (P-Basis), einer inneren N-Zone 3 (N-Basis) sowie einer anodenseitigen P-Zone 4 (P-Emitter). Der schraffierte Teilbereich 3a der N-Basis 3 entspricht der obengenannten Stoppschicht. Der kathodenseitige N-Emitter 1 und der anodenseitige P-Emitter 4 sind mit jeweils einer Hauptelektrode 1a und 4a und die P-Basis 2 mit einer Steuerelektrode 2a kontaktiert. In Fig. 2 ist in einem Diagramm das typische Dotierungsprofil des Halbleiterbauelements nach Fig. 1 senkrecht zur Schichtung der Zonen gezeichnet, wie es sich durch bekannte Diffussions- und Epitaxialtechniken etwa herstellen lässt. Im Teilbereich 3a der N-Basis 3, also der Stoppschicht, ist die Dotierungsüberhöhung über dem ansonsten konstant niedrigen Dotierungsniveau C der N-Basis 3 erkennbar. Liegt an den Hauptelektroden 1a und 4a eine vorwärtsgepolte Spannung an, so sperrt der PN-Übergang zwischen der P-Basis 2 und der N-Basis 3, indem sich dort eine Sperrschicht ausbildet. Die beiden äusseren PN-Übergänge sind in diesem Fall vorwärtsgepolt. Mit wachsender Sperrspannung dehnt sich die Sperrschicht am mittleren PN-Übergang in der P-Basis 2 und der N-Basis 3 aus, wobei die Ausdehnungsweite der Bedingung unterliegt, dass das Integrad über die Dotierungskonzentration C vom PN-Übergang bis zum jeweiligen Rand der Sperrschicht auf beiden Seiten des Übergangs gleich gross ist. Durch die in Fig. 2 bei $X_1$ und $X_2$ eingezeichneten Grenzlinien ist die Weite $W_s$ der Sperrschicht bei maximaler Sperrspannung markiert. Die Sperrschicht erstreckt sich, wie zu sehen ist, über den gesamten schwach dotierten Bereich der N-Basis 3, dringt auf Grund der obigen Integralbedingung aber nur wenig in die Stoppschicht 3a ein.

Ein geeigneter und realisierbarer Zahlenwert für die maximale Dotierungskonzentration $C_{max}$ der Stoppschicht liegt zwischen $2 \cdot 10^{15}$ cm$^{-3}$ und $4 \cdot 10^{16}$ cm$^{-3}$, besser noch zwischen $4 \cdot 10^{15}$ cm$^{-3}$ und $1 \cdot 10^{16}$ cm$^{-3}$. Der Wert $C_{min}$, auf den die Dotierungskonzentration C in der Stoppschicht 3a jenseits des Maximums $C_{max}$ von dem anodenseitigen P-Emitter 4 mindestens abfallen soll, berechnet sich in Relation zu $C_{max}$ nach $5 \cdot 10^{12}$ cm$^{-3} \cdot C_{max}$. Der Ort an dem die Dotierungskonzentration C den Wert $C_{min}$ in der Stoppschicht 3a erreicht ist in Fig. 2 mit $X_3$ bezeichnet. Neben der Erhöhung des Emitterwirkungsgrades ergibt sich aus der Dotierungsabsenkung ein weiterer Vorteil aus der Tatsache, dass sich entlang des Konzentrationsgradienten in der Stoppschicht 3a ein elektrisches Feld aufbaut, das den vom P-Emitter 4 injizierten Minoritätsladungsträgern entgegenwirkt und dem Transport dieser Minoritätsladungsträger über die sogenannte neutrale Zone zum Rand der Sperrschicht bei $X_2$ behindert. Die neutrale Zone erstreckt sich vom Rand der Sperrschicht bei $X_2$ bis zum Ort $X_4$, bei dem die Dotierungskonzentration C im P-Emitter 4 den Wert von $1 \cdot 10^{18}$ cm$^{-3}$ erreicht. Das elektrische Gegenfeld erlaubt in vorteilhafter Weise eine Reduzierung der Weite $W_n$ der neutralen Zone zur Reduzierung der Durchlassspannung nach dem Zünden des Thyristors, ohne im Sperrzustand gleichzeitig den Sperrstrom zu erhöhen. Das elektrische Gegenfeld ist umso grösser und wirksamer, je steiler der Konzentrationsabfall vor $X_3$ auf $C_{min}$ ist. Als Mass für die Steilheit dieses Abfalls kann relativ zum idealen Grenzfall der sprunghaften Änderung von $C_{max}$ auf $C_{min}$ bei $X_3$ ein Füllfaktor F definiert werden durch

$$F = \frac{\displaystyle\int_{X_2}^{X_3} C(X)\, dx}{C_{max} \cdot (X_3 - X_2)}$$

d.h., durch das Integral über die Dotierungskonzentration C vom Rand der Sperrschicht bei $X_2$ bis zum Ort $X_3$, das normiert ist auf das Integral über eine konstante Dotierungskonzentration der Höhe $C_{max}$ zwischen den gleichen Grenzen. Der Ort $X_3$ liegt am besten in der Mitte der neutralen Zone und sollte auf jeden Fall mindestens 30 Prozent ihrer Weite $W_n$ von ihren Rändern bei $X_2$ und $X_4$ entfernt sein. Für die Weite $W_n$ selbst ist ein Wert zwischen $10^{-3}$ cm und $8 \cdot 10^{-3}$ cm, besonders jedoch ein Wert vorteilhaft, der sich nach der Vorschrift

$$W_n = \frac{0{,}6}{F} \frac{\tau_R}{\tau_G} \cdot \sqrt{\frac{10^{14} \text{ cm}^{-3}}{C_{max}}} \cdot W_s$$

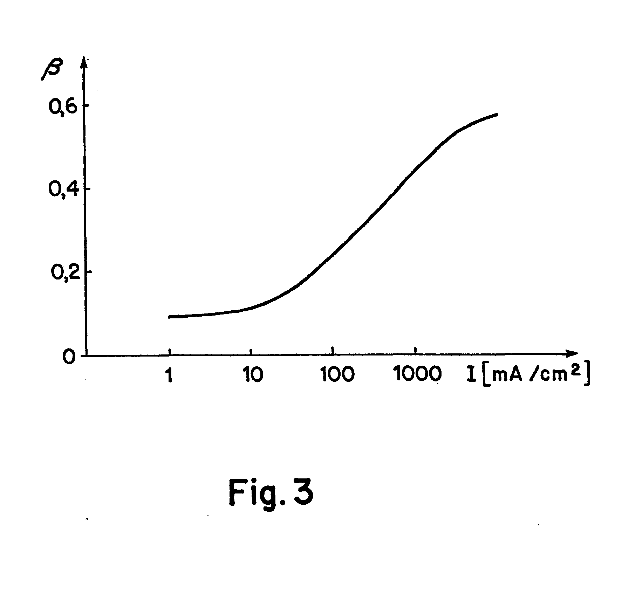

berechnet, wobei $\tau_R$ die mittlere Rekombinationslebensdauer der Minoritätsladungsträger in der Stoppschicht 3a, $\tau_G$ die mittlere Generationslebensdauer der Minoritätsladungsträger in der Sperrschicht mit der Weite $W_s$ bedeuten und F der oben definierte Füllfaktor ist. Nach dem Zünden des Thyristors über die Steuerelektrode 2a wird die gesamte Basiszone 2, 3 einschliesslich der Stoppschicht 3a mit Ladungsträgern in so hoher Konzentration überschwemmt, dass die um Grössenordnungen kleinere Konzentration der durch die Dotierung ortsgebundenen Ladungen in der Stoppschicht 3a gegen die Zahl der freien Ladungen nicht mehr ins Gewicht fällt. Dadurch wird das elektrische Gegenfeld in der Stoppschicht 3a fast vollständig abgebaut und stellt für den Ladungsträgertransport keinen merklichen Widerstand mehr dar. Das bedeutet mit anderen Worten, dass der Transportfaktor $\beta$ für die vom P-Emitter in die Stoppschicht 3a injizierten Minoritätsladungsträger bis zum Ort $X_2$ in vorteilhafter Weise eine Funktion der Stromdichte wird, d.h., der Transportfaktor $\beta$ ist klein für eine kleine Stromdichte im Sperrzustand und gross für eine hohe Stromdichte im Durchlasszustand. Diese funktionale Abhängigkeit ist in Fig. 3 dargestellt.

**Patentansprüche**

1. Halbleiterbauelement
- mit mindestens vier schichtweise aneinandergrenzenden Zonen (1, 2, 3, 4) abwechselnd entgegengesetzten Leitungstyps,
- bei welchem die beiden äusseren Zonen (1, 4) P- bzw. N-dotiert und jeweils mit einer Hauptelektrode (1a, 4a) kontaktiert sind, und
- bei welchem die P-dotierte (2) der beiden inneren Zonen (2, 3) durch eine Ausnehmung in der angrenzenden äusseren N-dotierten Zone (1) mit einer Steuerelektrode (2a) kontaktiert ist, und

– bei welchem in einem unmittelbar an die äussere P-dotierte Zone (4) angrenzenden Teilbereich (3a) der inneren N-dotierten Zone (3) die Dotierungskonzentration (C) Werte aufweist, die über dem niedrigen Dotierungsniveau des übrigen Teils der inneren N-dotierten Zone liegen, und

– bei welchem die Dotierungskonzentration (C) in dem Teilbereich (3a) senkrecht zur Schichtung der Zonen (1, 2, 3, 4) in Richtung auf die äussere P-dotierte Zone (4) von einem höheren ($C_{max}$) auf einen tieferen Wert ($C_{min}$) abfällt, dadurch gekennzeichnet, dass

– die beiden äusseren Zonen (1, 4) hoch dotiert sind, und

– die Dotierungskonzentration (C) den Wert $C_{min}$ an einem Ort ($X_3$) erreicht, der von den Rändern einer neutralen Zone, die sich vom Rand der Sperrschicht in der inneren N-dotierten Zone (3) bei maximaler an den Hauptelektroden anliegenden Vorwärtssperrspannung bis zu einem Ort ($X_4$) erstreckt, bei dem die Dotierungskonzentration in der äusseren P-dotierten Zone (4) den Wert $1 \cdot 10^{18}\,\mathrm{cm}^{-3}$ erreicht, mindestens 30 Prozent ihrer Weite ($W_n$) entfernt ist.

2. Halbleiterbauelement nach Anspruch 1, dadurch gekennzeichnet, dass im Teilbereich (3a) der inneren N-dotierten Zone (3) die Dotierungskonzentration (C) ein Maximum aufweist und dass der Maximalwert ($C_{max}$) zwischen $2 \cdot 10^{15}\,\mathrm{cm}^{-3}$ und $4 \cdot 10^{16}\,\mathrm{cm}^{-3}$, vorzugsweise zwischen $4 \cdot 10^{15}\,\mathrm{cm}^{-3}$ und $1 \cdot 10^{16}\,\mathrm{cm}^{-3}$ liegt.

3. Halbleiterbauelement nach den Ansprüchen 1 oder 2, dadurch gekennzeichnet, dass die Weite der neutralen Zone ($W_n$) im Bereich zwischen $1 \cdot 10^{-3}\,\mathrm{cm}$ und $8 \cdot 10^{-3}\,\mathrm{cm}$ liegt, vorzugsweise aber einen Wert besitzt, der sich nach der Vorschrift

$$W_n = \frac{0{,}6}{F} \frac{\tau_R}{\tau_G} \cdot \sqrt{\frac{10^{14}\,\mathrm{cm}^{-3}}{C_{max}}} \cdot W_s$$

berechnet, wobei $\tau_R$ die mittlere Rekombinationslebensdauer der Minoritätsladungsträger im Teilbereich (3a), $\tau_G$ die mittlere Generationslebensdauer der Minoritätsladungsträger in der Sperrschicht mit der Weite $W_s$ bedeutet, und F definiert ist durch

$$F = \frac{\displaystyle\int_{X_2}^{X_3} C(X)\,dx}{C_{max} \cdot (X_3 - X_2)}$$

d.h., durch das Integral über die Dotierungskonzentration (C) vom Rand der Sperrschicht in der inneren N-dotierten Zone (3) bei $X_2$, bis zum Ort $X_3$, an dem die Dotierungskonzentration (C) im Teilbereich (3a) den Wert $C_{min}$ erreicht, und das normiert ist auf das Integral über eine konstante Dotierungskonzentration der Höhe $C_{max}$ zwischen den gleichen Grenzen.

## Claims

1. Semiconductor component
– having at least four zones (1, 2, 3, 4) which adjoin each other in layers and which are of alternately opposite type of conduction,

– in which the two outer zones (1, 4) are P- and N-doped, respectively, and are in each case bonded to a main electrode (1a, 4a), and

– in which the P-doped zone (2) of the two inner zones (2, 3) is bonded to a control electrode (2a) through an opening in the adjoining outer N-doped zone (1), and

– in which in a part area (3a), immediately adjoining the outer P-doped zone (4), of the inner N-doped zone (3) the doping concentration (C) has values which are above the low doping level of the remaining part of the inner N-doped zone, and

– in which the doping concentration (C) in the part area (3a) drops from a higher ($C_{max}$) to a lower value ($C_{min}$) perpendicularly to the layering of the zones (1, 2, 3, 4) in the direction of the outer P-doped zone (4), characterized in that

– the two outer zones (1, 4) are highly doped, and

– the doping concentration (C) reaches a value of $C_{min}$ at a location ($X_3$) which is distant from the edges of a neutral zone which extends from the edge of the barrier layer in the inner N-doped zone (3) at maximum off-state forward voltage present at the main electrodes to a location ($X_4$) at which the doping concentration reaches a value of $1 \cdot 10^{18}\,\mathrm{cm}^{-3}$ in the outer P-doped zone (4), by at least 30 percent of its width ($W_n$).

2. Semiconductor component according to Claim 1, characterized in that the doping concentration (C) is at a maximum in the part area (3a) of the inner N-doped zone (3) and that the maximum value ($C_{max}$) is between $2 \cdot 10^{15}\,\mathrm{cm}^{-3}$ and $4 \cdot 10^{16}\,\mathrm{cm}^{-3}$, preferably between $4 \cdot 10^{15}\,\mathrm{cm}^{-3}$ and $1 \cdot 10^{16}\,\mathrm{cm}^{-3}$.

3. Semiconductor component according to Claims 1 or 2, characterized in that the width of the neutral zone ($W_n$) is within the range of between $1 \cdot 10^{-3}\,\mathrm{cm}$ and $8 \cdot 10^{-3}\,\mathrm{cm}$ but has preferably a value which is calculated in accordance with the rule

$$W_n = \frac{0{,}6}{F} \frac{\tau_R}{\tau_G} \cdot \sqrt{\frac{10^{14}\,\mathrm{cm}^{-3}}{C_{max}}} \cdot W_s$$

where $\tau_R$ is the mean recombination life of the minority charge carriers in the part area (3a), $\tau_G$ is the mean generation life of the minority charge carriers in the barrier layer having the width $W_s$, and F is defined by

$$F = \frac{\displaystyle\int_{X_2}^{X_3} C(X)\,dx}{C_{max} \cdot (X_3 - X_2)}$$

that is to say by the integral over the doping concentration (C) from the edge of the barrier layer in the inner N-doped zone (3) at $X_2$ to location $X_3$, at which the doping concentration (C) in the part area (3a) reaches the value $C_{min}$ and which is normalised to the integral over a constant doping concentration of the level $C_{max}$ between the same boundaries.

## Revendications

1. Composant semi-conducteur

– comportant au moins quatre zones juxtaposées par couches (1, 2, 3, 4) de types de conductivité opposés en alternance,

– dans lequel les deux zones extérieures (1, 4) sont à dopage P et N et sont chaque fois en contact avec une électrode principale (1a, 4a), et

– dans lequel la zone à dopage P des deux zones intérieures (2, 3) est en contact à travers un évidement dans la zone à dopage N extérieure adjacente (1) avec une électrode de commande (2a), et

– dans lequel, dans un domaine partiel (3a) de la zone à dopage N intérieure (3) immédiatement adjacent à la zone à dopage P extérieure (4), la concentration de dopage (C) présente des valeurs qui sont supérieures au niveau de dopage peu élevé du reste de la zone à dopage N intérieure, et

– dans lequel la concentration de dopage (C) dans le domaine partiel (3a), perpendiculairement à la direction de disposition en couches des zones (1, 2, 3, 4), va en diminuant en direction de la zone à dopage P extérieure (4) depuis une valeur supérieure ($C_{max}$) vers une valeur inférieure ($C_{min}$), caractérisé en ce que

– les deux zones extérieures (1, 4) sont fortement dopées, et

– la concentration de dopage (C) atteint la valeur $C_{min}$ en un endroit ($X_3$) qui est espacé des bords d'une zone neutre, qui s'étend depuis le bord de la couche de barrage dans la zone à dopage N intérieure (3) pour une tension à l'état bloquant en sens direct maximale sur les électrodes principales jusqu'à un endroit ($X_4$) pour lequel la concentration de dopage dans la zone à dopage P extérieure (4) atteint la valeur $1 \cdot 10^{18}$ cm$^{-3}$, d'au moins 30% de sa largeur ($X_n$).

2. Composant semi-conducteur suivant la revendication 1, caractérisé en ce que dans le domaine partiel (3a) de la zone à dopage N intérieure (3), la concentration de dopage (C) présente un maximum et la valeur maximale ($C_{max}$) est comprise entre $2 \cdot 10^{15}$ cm$^{-3}$ et $4 \cdot 10^{16}$ cm$^{-3}$, de préférence entre $4 \cdot 10^{15}$ cm$^{-3}$ et $1 \cdot 10^{16}$ cm$^{-3}$.

3. Composant semi-conducteur suivant la revendication 1 ou 2, caractérisé en ce que la largeur de la zone neutre ($X_n$) est comprise dans le domaine entre $1 \cdot 10^{-3}$ cm et $8 \cdot 10^{-3}$ cm, mais a de préférence une valeur qui se calcule d'après la règle

$$W_n = \frac{0{,}6}{F} \frac{\tau_R}{\tau_G} \cdot \sqrt{\frac{10^{14} \text{ cm}^{-3}}{C_{max}}} \ W_s$$

où $\tau_R$ désigne la durée de vie de recombinaison moyenne des porteurs de charges minoritaires dans le domaine partiel (3a), $\tau_G$ la durée de vie de génération moyenne des porteurs de charges minoritaires dans la couche de barrage de largeur $W_s$ et défini par

$$F = \frac{\displaystyle\int_{X_2}^{X_3} C(X)\, dx}{C_{max} \cdot (X_3 - X_2)}$$

c'est-à-dire par l'intégrale de la concentration de dopage (C) à partir du bord de la couche de barrage dans la zone à dopage N intérieure (3) en $X_2$ jusqu'à l'endroit $X_3$, où la concentration de dopage (C) dans le domaine partiel (3a) atteint la valeur $C_{min}$ et qui est normalisée sur l'intégrale d'une concentration de dopage constante de la hauteur ($C_{max}$) entre les mêmes limites.

**Fig. 1**

**Fig. 2**

Fig. 3